# EUROPEAN PATENT APPLICATION

(11) **EP 1 081 836 A2**
(43) Date of publication of application: **07.03.2001**
(21) Application number: 00307634.6
(22) Date of filing: 04.09.2000
(51) Int. Cl.: H02M 3/07

(54) **Charge pump circuit**

(30) Priority: 04.09.1999 US 389691
(71) Applicant: Texas Instruments Incorporated, Dallas, Texas 75251 (US)
(72) Inventor: Grant, David, Dallas, Texas 75206 (US)
(74) Representative: Legg, Cyrus James Grahame

(57) **Abstract**

A circuit, (54) comprising a plurality of switches (S₁, S₂, S₃, S₄ and S₅) coupled together in a charge pump arrangement (56). A first switch (S₁) is driven by a first driver (X₁), and a second switch (S₂) is driven by a second driver (X₂). The first and second switches (S₁ and S₂) are connected to the input voltage terminal (Vᵢₙ). The charge pump arrangement (56) is adapted to provide a boot voltage (V_{boot}) and a drive voltage (V_{dry}) for a switch mode power supply. At least the first driver (X₁) is powered by a voltage higher than the input voltage (Vᵢₙ). The higher voltage maybe obtained from a voltage (V₃) at a node between an additional switch (S₆) and an additional capacitor (C₃). Alternatively, the higher voltage may be obtained from the boot voltage (V_{boot}). Powering the driver (X₁) with the higher voltage allows the lateral semiconductor area of the charge pump circuit (56) to be reduced, by using NMOS FETs for at least one switch. The invention is particularly useful for applications such as DSPs and mixed signal or analog circuits.

## Description

This invention relates to integrated circuits, more specifically to integrated charge pump circuits and especially to a charge pump circuit integrated with a switching converter.

Integrated circuits (ICs) have moved progressively towards lower working voltages, lower power consumption and higher operating frequencies and, as overall system size has continued to decrease, IC power supply designs with smaller size and higher efficiency are demanded. Switch mode power supplies, which are a form of DC to DC converter, are used in IC circuits including digital signal processors (DSPs) and mixed signal analog circuits for efficient conversion of an input supply voltage to voltage levels appropriate for internal circuitry as well as external circuitry that the IC is coupled to. For instance, a 2.8 volt supply voltage provided to a BiCMOS IC may need to be increased internally to 5.0 volts to operate internal CMOS circuitry. As appliances and circuit designs continue to decrease in size, the need for smaller and more efficient IC switch mode power converters increases.

The invention provides a charge pump circuit which, in operation, receives an input voltage difference at an input port and provides a boosted voltage difference of greater magnitude than that of the input voltage difference derived from the input voltage difference, the charge pump circuit being connected to supply the boosted voltage difference at an output port and being connected to feed back a voltage level outside the range of the input voltage difference and derived from the boosted voltage difference, so as supply at least a part of the charge pump circuit with that voltage level.

Preferably, the voltage level fed back is more positive than both the input voltage levels that form the input voltage difference.

Preferably, the more negative ones of each of the input and boosted voltage levels are the same level.

Preferably, the voltage level fed back is equal to one of the voltage levels that form the boosted voltage difference.

Preferably, the charge pump circuit includes at least one N-channel metal oxide semiconductor (NMOS) transistor, the output port being connected to provide the gate terminal supply voltage for the or each NMOS transistor.

One embodiment of the charge pump circuit includes:
means for receiving an input voltage,
a plurality of switches coupled together in a charge pump arrangement,
a means of producing a second voltage which is the output voltage higher than the input voltage, the means being integral with the circuit and
the charge pump arrangement including a first switch and at least the first switch being driven by the second voltage.

Preferably, the first switch is driven by a first driver, another of the switches comprises a second switch driven by a second driver and the charge pump arrangement is capable of providing a boot voltage at a boot voltage terminal and a drive voltage for a switch mode power supply.

Preferably, the second driver is powered by the second voltage.

Preferably, the charge pump circuit further comprises:
a third switch coupled to the boot voltage terminal and
a capacitor including a first terminal connected to the third switch and a second terminal connected to a ground terminal, the first terminal of the capacitor powering the first driver and the second driver.

Preferably, the voltage at the first terminal of the capacitor is 2.5 volts or greater.

Preferably,the boot voltage powers the first driver.

Preferably, the circuit comprises a semiconductor material and at least the first and second switches of the charge pump arrangement comprise NMOS FETs, reducing the lateral physical area of the semiconductor material of the charge pump circuit by at least one-half compared with a charge pump circuit including only PMOS FETs.

A pump circuit and a switch mode power converter may so connected together that, in operation, the charge pump circuit provides the boosted voltage difference to at least a part of the switch mode power converter.

A circuit may include a charge pump circuit so connected to a switch mode power converter that the switch mode power converter is powered by the charge pump circuit and comprise:
a first, second, third, fourth and fifth switch coupled together in the charge pump circuit, the first switch connected to an input voltage terminal and driven by a first driver, the second switch connected to the input voltage terminal and driven by a second driver, the charge pump arrangement providing a boot voltage at a boot voltage terminal,
a first capacitor coupled between the drive voltage terminal and a ground terminal,
a first transistor driven by the first driver and coupled to the input voltage terminal and a phase node,
a second capacitor including a terminal connected to the boot voltage terminal and another terminal connected to the phase node and
a second transistor coupled to the output of the second driver, the phase node and the ground terminal, wherein at least the first driver is powered by a voltage higher than the input voltage at the input voltage terminal.

Preferably, the second driver is powered by a voltage higher than the input voltage at the input voltage terminal.

The circuit may further comprise:
a sixth switch coupled to the boot voltage terminal and
a third capacitor including a first terminal connected to the ground terminal and a second terminal coupled to the sixth switch, the voltage at the second terminal of the third capacitor powering at least the first driver driving the first switch of the charge pump circuit.

Preferably, the voltage at the second terminal of the third capacitor is connected to a voltage supply terminal of the second driver for driving the second switch.

Preferably, the first driver for driving the first switch is powered by the boot voltage.

Preferably, the converter comprises a semiconductor material and at least the first and second switches of the charge pump circuit comprise NMOS FETs, reducing the lateral physical area of the semiconductor material of the charge pump circuit compared with a charge pump circuit including only PMOS FETs.

Preferably, the voltage at the second terminal on the third capacitor is 2.5 volts or greater.

Preferably, in the charge pump circuit,
the third switch is coupled to the second switch and the ground terminal,
the fourth switch is coupled to the first switch and to the drive voltage terminal and
the fifth switch is coupled to the first switch and the boot voltage terminal.

The invention provides a method of operating a charge pump circuit including the steps of:
supplying an input voltage difference to an input port of the charge pump circuit,
so driving the charge pump circuit as to provide at an output port, from the input voltage difference, a boosted voltage difference of greater magnitude than that of the input voltage difference,
providing the boosted voltage difference voltage at an output port and
feeding back a voltage level outside the range of the input voltage difference and derived from the boosted voltage difference, so as to supply at least a part of the charge pump circuit with that voltage level.

The method may include the steps of:
providing a plurality of switches coupled together in a charge pump arrangement and operating from the input voltage, the plurality of switches including at least a first switch and a second switch, the first and second switches being driven by a first driver and second driver, respectively,
generating a second voltage internal to the circuit, the second voltage being the output voltage which is higher than the input voltage and
powering at least the first driver with the second voltage.

Preferably, the method further comprises the step of:
powering the second driver with said second voltage.

Preferably, the method further comprises the steps of:
providing a third switch having a first and second terminal,
connecting a capacitor at the second terminal of the third switch and
so switching the third switch as to generate the second voltage at the first terminal of the third switch.

Preferably, at least the first switch is an NMOS FET.

Preferably, the method further comprises the step of:
coupling the second voltage of the circuit to a switch mode power converter.

The present invention achieves technical advantages as a charge pump adapted for use in a circuit, the charge pump having switches driven by a voltage higher than an input voltage to the circuit, resulting in the ability to use smaller NMOS FETs as switches, saving semiconductor real estate.

In one embodiment, a circuit is adapted to receive an input voltage, including a means of producing a second voltage higher than the input voltage, the means being integral to the circuit. The circuit includes a plurality of switches coupled together in a charge pump arrangement, including a first switch, where at least the first switch is driven by the second voltage. The first switch may be driven by a first driver, and another of the switches may be a second switch driven by a second driver. The charge pump arrangement may be adapted to provide a boot voltage at a boot voltage terminal and a drive voltage for a switch mode power supply. The higher voltage may be obtained from a voltage at a node between an additional switch and an additional capacitor, or alternatively, the higher voltage may be obtained from the boot voltage.

In another embodiment, a switch mode power converter powered by a charge pump circuit includes a first, second, third, fourth and fifth switch coupled together in a charge pump circuit. The first switch is connected to an input voltage terminal and is driven by a first driver. The second switch is connected to an input voltage terminal and is driven by a second driver. The charge pump arrangement provides a boot voltage at a boot voltage terminal for a third driver and a drive voltage at a drive voltage terminal to a fourth driver. A first capacitor is coupled between the drive voltage terminal and a ground terminal. The first transistor is driven by the first driver and is coupled to the input voltage terminal and a phase node. The second capacitor is connected at one end to the boot voltage terminal and at the other end to the phase node. A second transistor is coupled to the output of the second driver, the phase node and the ground terminal. At least the first driver is powered by a voltage higher than the input voltage at the input voltage terminal. The higher voltage may be obtained from a voltage at a node between an additional switch and an additional capacitor, or alternatively, the higher voltage may be obtained from the boot voltage.

Also disclosed is a method of reducing the lateral semiconductor area of a charge pump circuit. The method includes the step of providing a plurality of switches coupled together in a charge pump arrangement, where the charge pump arrangement is adapted to provide a boot voltage at a boot voltage terminal for a switch mode power supply. The plurality of switches includes at least a first switch and a second switch coupled to an input voltage terminal. The first and second switches are driven by a first driver and a second driver, respectively. The method includes the step of powering at least first driver with a voltage higher than input voltage. The higher voltage may be obtained from a voltage at a node between an additional switch and an additional capacitor, or alternatively, the higher voltage may be obtained from the boot voltage.

Advantages of the present invention include at least one driver of a switch in the charge pump circuit being powered by a voltage higher than the input voltage of the circuit, which allows NMOS FETs to be used for the majority of the switches in the charge pump circuit, resulting in semiconductor real estate savings of one-half to on-third. Another advantage of the present invention is that noise generated by the charge pump is inherently synchronous to the main switching converter, which reduces the likelihood that charge pump noise will interfere with the main converter. A further advantage of the present invention is that the main load of the charge pump is the gate charge required for the main switching converter power FETs, synchronizing the charge pump to the main converter, making the charge pump output approximately track the demand. Also, the second embodiment of the present invention requires no additional components to achieve a boot voltage higher than the input voltage powering the driver of the first switch.

A circuit in accordance with the invention will now be described, by way of example only, with reference to the accompanying drawings in which:
Figure 1 is a block diagram representing a charge pump circuit combined with a switch mode converter,
Figure 2 is a block diagram representing a first embodiment of the invention,
Figure 3 is a timing diagram for the circuit shown in Figure 2,
Figure 4 is a more detailed view of portions of the circuit shown in Figure 2,
Figure 5 is a block diagram representing a second embodiment of the invention and
Figure 6 is a timing diagram for the circuit shown in Figure 5.

Like numerals and symbols are employed in different figures to designate similar components in various views unless otherwise indicated.

A problem with prior art switching converters with charge pumps is that the charge pump circuitry requires low resistance FETs in order to obtain a high efficiency. Low-resistance FETs must be PMOS and require a large amount of area of silicon material, for example between 75,000 to 100,000 square microns. A charge pump circuit is needed in art having a high efficiency yet can utilize smaller FETs such as NMOS FETs which require one-half to two-thirds the area that PMOS FETs require, saving semiconductor real estate.

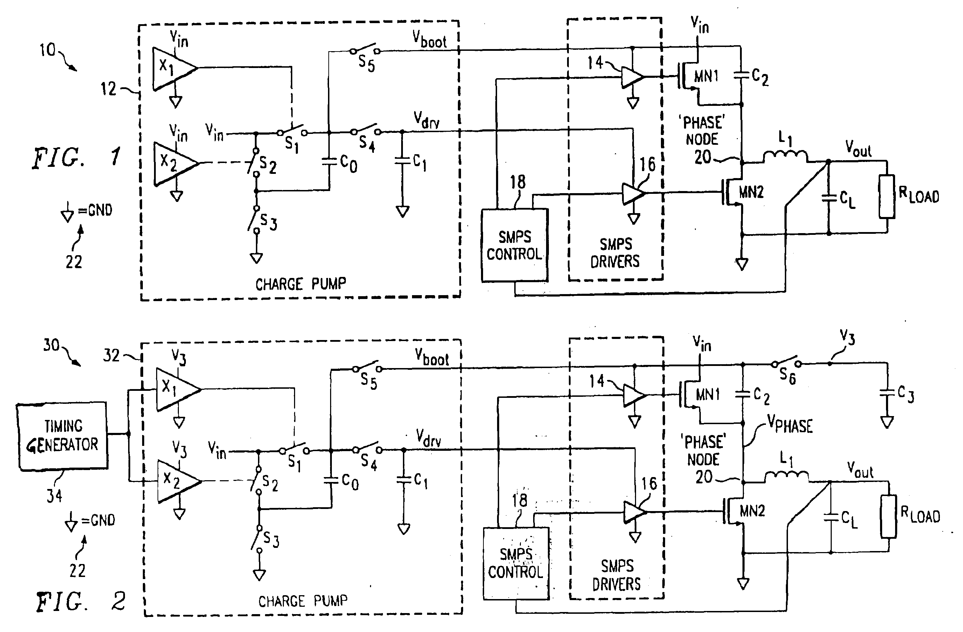

Figure 1 illustrates a block diagram of a switch mode converter 10 powered from a charge pump 12. The charge pump 12 initially runs from an internal oscillator (not shown), until the capacitors C₁ and C₂ are fully charged. Once both capacitors C₁ and C₂ are charged, the main switch mode converter is started. The switch mode converter alternately turns transistors MN₁ and MN₂ on, causing the phase node 20 to swing between 0 V and Vᵢₙ. The transistors MN₁ and MN₂ are often field effect transistors (FETs). The phase node 20 is tied to one end of capacitor C_{2.} The other end of capacitor C₂ provides the power supply for the driver 14 for transistor MN₁. When transistor MN₁ begins to turn on, the phase node 20 rises, increasing the drive voltage for transistor MN₁. The charge required to turn on transistor MN₁ is supplied from capacitor C₂. When the transistor MN₁ turns off and transistor MN₁ turns on, the phase node 20 is brought down to 0V and capacitor C₂ is recharged by switch S₅.

The charge pump 12 may include a first driver X₁ and a second driver X₂ that are used to drive switches S₁ and S₂, respectively. The drivers X₁ and X₂ are powered by input voltage Vin. The charge pump 12 is used to increase the supply voltage to a switching converter to allow the converter to drive external transistors, which may be inexpensive FETs with a high voltage threshold Vₜ. To achieve a charge pump 12 with a high efficiency, low resistance PMOS FETs are typically used in the art for the switches S₁, S₂, S₄, and S₅ of the charge pump 12, which may require up to approximately twice the amount of semiconductor real estate that NMOS FETs require. Switch S₃ is typically an NMOS FET.

Figure 2 illustrates a block diagram of a first embodiment of the present invention, a circuit 30 including a charge pump 32 driving SMPS drivers 14 and 16. The charge pump comprises a first driver X₁ and a second driver X₂, the drivers obtaining a clock signal by timing generator 34. Switches S₁ and S₂ are driven by the first driver X₁ and second driver X₂, respectively. A switch S₃ is coupled to capacitor C₀ and a ground terminal 22. Switch S₄ is coupled to C₀ and S₁, as well as switch S₅. The signal from switch S₅ is the voltage Vboot which is used to power driver 14. The signal V_{drv} at switch S₄ is used to power driver 16. Signal V_{drv} is connected to capacitor C₁, which capacitor C₁ is connected to ground terminal 22. Drivers 14 and 16 are controlled by SMPS control 18. Driver 14 is controllably coupled to transistor MN₁, and driver 16 is controllably coupled to transistor MN₂. A capacitor C₂ is connected to the source of transistor MN₁ at one end and to the node containing signal V_{boot} at the other end. The node at the source of transistor MN₁ defines a phase node 20 at which the signal Vₚₕₐₛₑ is located. The drain of transistor MN₂ is coupled to the phase node 20, and the source of transistor MN₂ is connected to ground terminal 22. An inductor L₁ is connected at one end to the phase node 20 and at the other end to an output terminal Vₒᵤₜ. A load capacitor C_{L} and a load R_{load} comprising a processor, DSP, or logic IC, for example, are coupled across Vₒᵤₜ and the ground terminal 22. The circuit 30 provides an output voltage Vₒᵤₜ when an input voltage Vᵢₙ is applied to the circuit.

In the preferred embodiment of the circuit 30 shown in Figure 2, an additional switch S₆ is connected at one end to the boot capacitor C₂ and also to an additional capacitor C₃ which is connected to the ground terminal 22 at the other end. The voltage at a node V₃ between capacitors C₃ and switch S₆ is used to power the drivers X₁ and X₂ of the charge pump 32. When the end of capacitor C₂ connected to V_{boot} is high, some of the charge from node V_{boot} is transferred through switch S₆ to capacitor C₃. The voltage at node V₃ is approximately equal to (Vᵢₙ plus V_{drv}) and is used to power drivers X₁ and X₂ for switches S₁ and S₂ , in the charge pump 32. Because V₃ is V_{drv} higher than Vᵢₙ, switches S₁ and S₂ are preferably NMOS devices, rather than being PMOS as in the prior art. This is advantageous because NMOS devices require the lowest amount of lateral semiconductor area for their required Rdsₒₙ. Using an NMOS FET may require 50,000 square microns versus the 75,000 to 100,000 square microns required by a PMOS FET. This results in a semiconductor real estate savings of 25,000 to 50,000 square microns, for each PMOS FET replaced by an NMOS FET. Switch S₃ is preferably NMOS and may be driven directly from V_{drv}. Depending on the minimum level of Vᵢₙ, it may also be possible to make S₄ an NMOS FET driven off V₃ because the gate drive of S₄ will be Vᵢₙ above V_{drv}. However, if Vᵢₙ is too low to allow sufficient gate drive for switch S₄, a PMOS FET maybe used. Preferably, switches S₁, S₂, S₃ and S₄ are NMOS FETs to save the most amount of semiconductor real estate, although any one or several of them may also be PMOS, as the circuit design requires. Switch S₅ is preferably a PMOS device.

Preferably in order to reduce diode losses internal to FETs, switches S₁, S₂, S₃, S₄, S₅, and S₆ are MOS transistors. The sequencing of the MOS FETs is very closely tied to the switching of the main converter. At initial power up, the main converter is not running, and the charge pump 32 pumps V_{drv} and V_{boot} up to their target voltages. The phase node 20 is initially at 0 V. The target voltage of boot voltage V_{boot} is approximately equal to V_{drv}. Also at initial power up, the charge pump 32 does not have V₃ available yet, so the charge pump 32 runs at reduced efficiency. However, the main load on the charge pump 32, the main load being the main converter comprising SMPS drivers 14 and 16, is not running, so full efficiency is not yet required. An auxiliary clock is preferably an external oscillator and is represented by the timing generator 34 generates the timing for the charge pump 32. Once voltages V_{drv} and V_{boot} are precharged sufficiently to start the main converter, the control of the timing of the charge pump 32 is handed over to the main converter and the main converter is then allowed to start. Once the main converter starts, the phase node 20 begins switching, so voltage V_{boot} now switches between V_{drv} and (V_{drv} + Vᵢₙ), and V₃ equals approximately (V_{drv} + Vᵢₙ). The charge pump 32 is able to run off a higher supply in accordance with the present invention, achieving full efficiency operation.

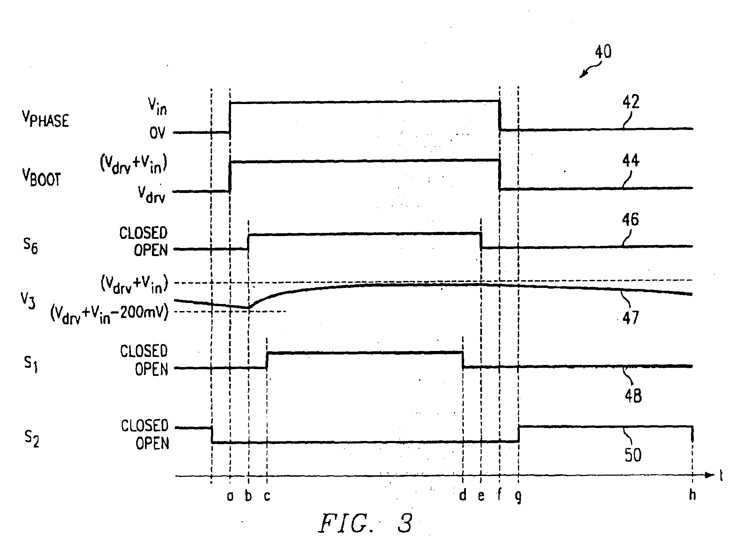

Figure 3 shows a timing diagram for the circuit 30 of Figure 2 once the system has been running for some time, with the x-axis representing time. At time "a," switch S₆ is open and Vₚₕₐₛₑ (signal 42) at the phase node 20 rises from 0 V to Vᵢₙ. V_{boot} (signal 44) is pushed up via the capacitor C₂ from approximately V_{drv} to (V_{drv} + Vᵢₙ). At time "b" switch S₆ closes (signal 46), allowing capacitor C₃ to charge from v_{boot}, shown at V₃ (signal 47). At time "c", the charge pump 32 reaches the point in its sequence when switch S₁ needs to be closed (signal 48). Because V_{boot} is at approximately (V_{drv} + Vᵢₙ), V_{boot} can be used to drive an NMOS FET rather than a PMOS FET of the prior art to perform the switching function for switch S₁. In the first embodiment where S₆ and capacitor C₃ are present, the voltage V₃ on capacitor C₃ is used to power the drivers X₁ and/or X₂ that drive the gates of switches S₁ and S₂, respectively, which switches are preferably NMOS FETs.

At time "d", switch S₁ is opened (signal 48) before V_{boot} falls again to V_{drv}. At time "e", switch S₆ is opened (signal 46) before V_{boot} falls to V_{drv}. At time "f", Vₚₕₐₛₑ and V_{boot} fall (signals 42 and 44, respectively). In the preferred embodiment, capacitor C₃ and switch S₆ are present so the voltage on V₃ (at signal 47) is held roughly equal to the peak voltage on V_{boot} (signal 44), or (V_{drv} + Vᵢₙ). At time "g" switch S₂ is closed (signal 50) and according to the preferred embodiment the voltage on V₃ (signal 47) is used to drive an NMOS FET for switch S₂. Voltage V₃ (signal 47) fluctuates from approximately (Vdrv + Vin - 200mV) to (Vdrv + Vin). At time "h", S₂ is closed again (signal 50) and the cycle is ready to restart.

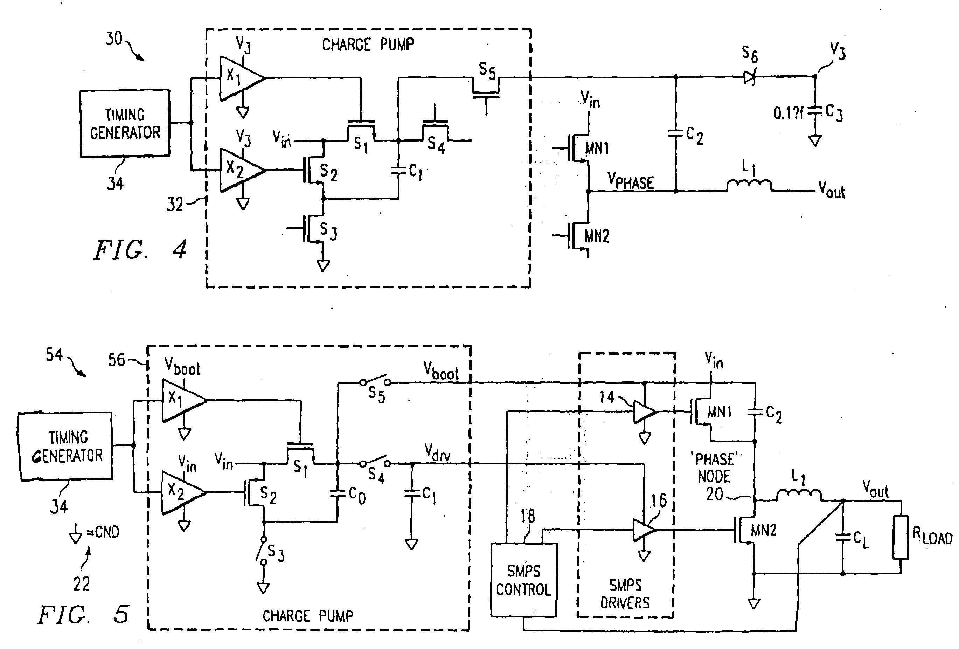

Figure 4 illustrates in more detail portions of the circuit 30 shown in Figure 2. The gates of switches S₁ and S₂, which preferably comprise NMOS FETs, are driven by drivers X₁ and X₂ respectively. Switch S₃ also preferably comprises an NMOS FET. A Schottky diode implemented for switch S₆, although a PMOS FET may also be used for switch S₆, as shown in Figure 2. Capacitor C₃ is preferably a capacitor of approximately 0.1 µF for example.

Figure 5 shows a second embodiment of the present invention where driver X₁ is powered from V_{boot} rather than Vᵢₙ. This is advantageous because one less pin is required on the device, compared with the first embodiment, and an external capacitor C₃ is not required as in the first embodiment. However, switch S₂ does not derive benefit from an increased gate drive and is powered by Vin as in the prior art. In this configuration, S₂ cannot be powered by V_{boot}, because V_{boot} is not in the high state when switch S₂ is required to be on. An additional advantage of the second embodiment is that an additional switch S₆ is not required, as in the first embodiment. However, the second embodiment is the less preferred implementation of the present invention because V₃ does not exist and switch S₂ must be implemented as a less efficient and real estate consuming PMOS FET device.

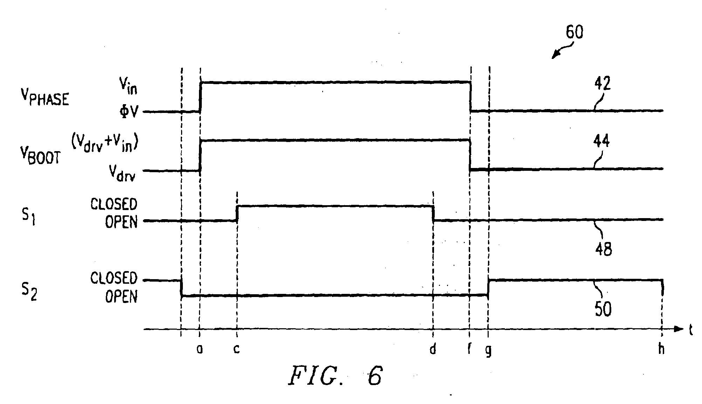

Figure 6 shows a corresponding timing diagram 60 for the second embodiment. The timing of the second embodiment is similar to that of the first embodiment, without S₆ and V₃ shown. At time "a," Vₚₕₐₛₑ (signal 42) at the phase node 20 rises from 0V to Vᵢₙ. V_{boot} (signal 44) is pushed up via the capacitor C₂ from approximately V_{drv} to (V_{drv} + Vᵢₙ). At time "c", the charge pump 32 reaches the point in its sequence when switch S₁ needs to be closed (signal 48). Because V_{boot} is at approximately (V_{drv} + Vᵢₙ), V_{boot} can be used to drive an NMOS FET rather than a PMOS FET of the prior art to perform the switching function for switch S₁. The voltage V_{boot} on boot capacitor C₂ is used to power the driver X₁ that drives the gate of switch S₁, which switch is preferably an NMOS FET. At time "d", switch S₁ is opened (signal 48) before V_{boot} falls again to V_{drv}. At time "f", Vₚₕₐₛₑ and V_{boot} fall (signals 42 and 44, respectively). At time "g" switch S₂ is closed (signal 50). At time "h" S₂ is closed again (signal 50) and the cycle is ready to restart.

One advantage of the present invention is that at least one driver of a switch in the charge pump circuit is powered by a voltage higher than the input voltage of the circuit. This allows NMOS FETs to be used for the majority of switches S₁, S₂, S₃, S₄ and S₅ in the charge pump circuit. Because NMOS FETs require less semiconductor area than the PMOS FETS used for switches in the prior art, the present invention saves semiconductor real estate.

Another advantage of the present invention is that noise generated by the charge pump is inherently synchronous to the main switching converter, which reduces the likelihood that charge pump noise will interfere with the main converter. This is particularly advantageous if the main converter is running fixed frequency to reduce interference, as it is often the case in sampled data system in communication systems, where the charge pump noise lies in the same frequency bands as the main converter noise.

Another advantage of the present invention is that the main load of the charge pump is the gate charge required for the main switching converter power FETs, which synchronizes the charge pump to the main converter, making the charge pump output approximately track the demand.

An advantage of the second embodiment of the present invention is that no additional components are required to achieve a voltage, Vboot, higher than voltage Vᵢₙ powering the driver X₁ of the first switch S₁. This allows the use of a semiconductor real estate saving PMOS FET for switch S₁.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. For example, preferably four of the five switches within the charge pump are implemented as NMOS FET devices in the present invention. However, fewer than four switches may be implemented as NMOS devices, as is advantageous in each particular application. The charge pump circuit of the present invention may be utilized with a power converter in a wide variety of applications, such as digital signal processors, microprocessors, telecommunications applications, mobile devices and systems, laptops and personal computers, mixed signal and analog devices, and any lower power electrical application, in general.

## Claims

1. A charge pump circuit which, in operation, receives an input voltage difference at an input port and provides a boosted voltage difference of greater magnitude than that of the input voltage difference derived from the input voltage difference, the charge pump circuit being connected to supply the boosted voltage difference at an output port and being connected to feed back a voltage level outside the range of the input voltage difference and derived from the boosted voltage difference, so as supply at least a part of the charge pump circuit with that voltage level.

2. A charge pump circuit as claimed in claim 1, wherein the voltage level fed back is more positive than both the input voltage levels that form the input voltage difference.

3. A charge pump circuit as claimed in claim 1 or claim 2, wherein the more negative ones of each of the input and boosted voltage levels are the same level.

4. A charge pump circuit as claimed in any one of claims 1 to 3, wherein the voltage level fed back is equal to one of the voltage levels that form the boosted voltage difference.

5. A charge pump circuit as claimed in any one of claims 1 to 4, including at least one N-channel metal oxide semiconductor (NMOS) transistor, the output port being connected to provide the gate terminal supply voltage for the or each NMOS transistor.

6. A charge pump circuit as claimed in any one of claims 1 to 5, including:
means for receiving an input voltage,
a plurality of switches coupled together in a charge pump arrangement,
a means of producing a second voltage which is the output voltage higher than the input voltage, the means being integral with the circuit and
the charge pump arrangement including a first switch and at least the first switch being driven by the second voltage.

7. A charge pump circuit as claimed in claim 6, wherein the first switch is driven by a first driver, another of the switches comprises a second switch driven by a second driver and the charge pump arrangement is capable of providing a boot voltage at a boot voltage terminal and a drive voltage for a switch mode power supply.

8. A charge pump circuit as claimed in claim 7, wherein the second driver is powered by the second voltage.

9. A pump circuit as claimed in claim 7 or claim 8, further comprising:
a third switch coupled to the boot voltage terminal and
a capacitor including a first terminal connected to the third switch and a second terminal connected to a ground terminal, the first terminal of the capacitor powering the first driver and the second driver.

10. A charge pump circuit as claimed in claim 9, wherein the voltage at the first terminal of the capacitor is 2.5 volts or greater.

11. A charge pump circuit as claimed in any one of claims 7 to 10, wherein the boot voltage powers the first driver.

12. A charge pump circuit as claimed in any one of claims 6 to 11, wherein the circuit comprises a semiconductor material and at least the first and second switches of the charge pump arrangement comprise NMOS FETs, reducing the lateral physical area of the semiconductor material of the charge pump circuit by at least one-half compared with a charge pump circuit including only PMOS FETs.

13. A pump circuit as claimed in any one of claims 1 to 12 and a switch mode power converter so connected together that, in operation, the charge pump circuit provides the boosted voltage difference to at least a part of the switch mode power converter.

14. A circuit including a charge pump circuit as claimed in any one of claims 1 to 12 so connected to a switch mode power converter that the switch mode power converter is powered by the charge pump circuit, comprising:
a first, second, third, fourth and fifth switch coupled together in the charge pump circuit, the first switch connected to an input voltage terminal and driven by a first driver, the second switch connected to the input voltage terminal and driven by a second driver, the charge pump arrangement providing a boot voltage at a boot voltage terminal,
a first capacitor coupled between the drive voltage terminal and a ground terminal,
a first transistor driven by the first driver and coupled to the input voltage terminal and a phase node,
a second capacitor including a terminal connected to the boot voltage terminal and another terminal connected to the phase node and
a second transistor coupled to the output of the second driver, the phase node and the ground terminal, wherein at least the first driver is powered by a voltage higher than the input voltage at the input voltage terminal.

15. A circuit as claimed in claim 14, wherein the second driver is powered by a voltage higher than the input voltage at the input voltage terminal.

16. A circuit as claimed in claim 14 or claim 15, further comprising:
a sixth switch coupled to the boot voltage terminal and
a third capacitor including a first terminal connected to the ground terminal and a second terminal coupled to the sixth switch, the voltage at the second terminal of the third capacitor powering at least the first driver driving the first switch of the charge pump circuit.

17. A circuit as claimed in claim 16, wherein the voltage at the second terminal of the third capacitor is connected to a voltage supply terminal of the second driver for driving the second switch.

18. A circuit as claimed in any one of claims 14 to 17, wherein the first driver for driving the first switch is powered by the boot voltage.

19. A circuit as claimed in any one of claims 14 to 18, wherein the converter comprises a semiconductor material and at least the first and second switches of the charge pump circuit comprise NMOS FETs, reducing the lateral physical area of the semiconductor material of the charge pump circuit compared with a charge pump circuit including only PMOS FETs.

20. A circuit as claimed in any one of claims 16 to 19, wherein the voltage at the second terminal on the third capacitor is 2.5 volts or greater.

21. A circuit as claimed in any one of claims 14 to 20, wherein, in the charge pump circuit,
the third switch is coupled to the second switch and the ground terminal,
the fourth switch is coupled to the first switch and to the drive voltage terminal and
the fifth switch is coupled to the first switch and the boot voltage terminal.

22. A method of operating a charge pump circuit including the steps of:
supplying an input voltage difference to an input port of the charge pump circuit,
so driving the charge pump circuit as to provide at an output port, from the input voltage difference, a boosted voltage difference of greater magnitude than that of the input voltage difference,
providing the boosted voltage difference voltage at an output port and
feeding back a voltage level outside the range of the input voltage difference and derived from the boosted voltage difference, so as to supply at least a part of the charge pump circuit with that voltage level.

23. A method as claimed in claim 22, including the steps of:
providing a plurality of switches coupled together in a charge pump arrangement and operating from the input voltage, the plurality of switches including at least a first switch and a second switch, the first and second switches being driven by a first driver and second driver, respectively,
generating a second voltage internal to the circuit, the second voltage being the output voltage which is higher than the input voltage and
powering at least the first driver with the second voltage.

24. A method as claimed in claim 23, further comprising the step of:
powering the second driver with said second voltage.

25. A method as claimed in claim 23 or claim 24, further comprising the steps of:
providing a third switch having a first and second terminal,
connecting a capacitor at the second terminal of the third switch and
so switching the third switch as to generate the second voltage at the first terminal of the third switch.

26. A method as claimed in any one of claims 23 to 25, wherein at least the first switch is an NMOS FET.

27. A method as claimed in any one of claims 23 to 26, further comprising the step of:
coupling the second voltage of the circuit to a switch mode power converter.
